(19) Europäisches Patentamt
European Patent Office
Office européen des brevets

(11) EP 0 803 566 B1

(12) **EUROPEAN PATENT SPECIFICATION**

(45) Date of publication and mention of the grant of the patent:
**10.09.2003 Bulletin 2003/37**

(21) Application number: **96938455.1**

(22) Date of filing: **13.11.1996**

(51) Int Cl.[7]: **C10M 141/10**, C10M 135/18, C10M 137/10, C10M 169/04 // (C10M141/10, 135:18, 135:18, 137:10), (C10N10/12, 10:04, 30:06, 40:25)

(86) International application number:
**PCT/JP96/03326**

(87) International publication number:
**WO 97/018282 (22.05.1997 Gazette 1997/22)**

(54) **LUBRICATING OIL FOR INTERNAL COMBUSTION ENGINE**

SCHMIERÖL FÜR BRENNKRAFTMASCHINEN

HUILE LUBRIFIANTE POUR MOTEUR A COMBUSTION INTERNE

(84) Designated Contracting States:
**DE FR GB**

(30) Priority: **13.11.1995 JP 31704695**

(43) Date of publication of application:
**29.10.1997 Bulletin 1997/44**

(73) Proprietor: **JAPAN ENERGY CORPORATION**
**Tokyo 105-0001 (JP)**

(72) Inventors:
- **HOSONUMA, Kunihiko**
  **Japan Energy Corporation**
  **Toda-shi Saitama-ken 335 (JP)**
- **MARUYAMA, Masaki Japan Energy Corporation**
  **Toda-shi Saitama-ken 335 (JP)**
- **NAITOH, Yasushi Japan Energy Corporation**
  **Toda-shi Saitama-ken 335 (JP)**

(74) Representative: **West, Alan Harry et al**
**R.G.C. Jenkins & Co.**
**26 Caxton Street**
**London SW1H 0RJ (GB)**

(56) References cited:

| | |
|---|---|
| **JP-A- 5 186 787** | **JP-A- 5 279 686** |
| **JP-A- 6 248 284** | **JP-A- 6 336 592** |
| **JP-A- 8 253 785** | **US-A- 5 356 547** |

Remarks:
The file contains technical information submitted after the application was filed and not included in this specification

EP 0 803 566 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

Printed by Jouve, 75001 PARIS (FR)

## Description

The present invention relates to a composition of a lubricating oil for internal combustion engine such as an engine oil for gasoline automobiles. More particularly, the present invention relates to a lubricating oil for internal combustion engine which can retain the fuel-saving effect for a longer period of time.

From a viewpoint of suppression of $CO_2$ content in the atmosphere which is considered one of the causes for making the earth warmer as well as resource-saving, the engine oils for the gasoline automobiles (hereinafter referred to briefly as "engine oil") have been strongly required to possess low fuel economy in addition to performances such as wear resistance, oxidation stability, detergency and dispersancy.

Ordinarily, the engine oil is composed of a mineral oil purified from petroleum, or a synthetic lubricating oil such as $\alpha$-olefin oligomer and ester, added with additives such as a detergent, a dispersant, an antioxidant, an anti-wear agent, and a viscosity index improver. In order to increase the fuel efficiency, it is effective to lower the viscosity of the engine oil. However, mere lowering of the viscosity increases a boundary lubricating area, which leads to increase in friction in some cases. For this reason, a friction modifier (FM) has recently come to be added to the engine oil so as to reduce friction in the boundary lubricating area. Among friction modifiers, organometallic additives are more effective than ashless additives such as ester, amine and amide additives. It is known that, among these, organic molybdenum compounds such as molybdenum dithiocarbamate (MoDTC) and oxymolybdenum organo phosphorodithioate sulfide (MoDTP) are highly effective as described in Japanese Patent Laid -open No.3-23595. It is also reported that the use of MoDTC together with zinc dithiophosphate (ZnDTP) affords the higher friction decreasing effect.

However, the use of the engine oil in the course of time is accompanied by deterioration of and consumption of the above mentioned organo molybdenum compound. Therefore, there is a problem that, although a fresh engine oil gives a low fuel economy, such a low fuel economy of the engine oil is deteriorated with the lapse of time. In order to solve the above problem, it can be considered that the addition amount of the organo molybdenum compound in a fresh oil is increased. Further, MoDTP among the organic molybdenum compounds contains phosphorous, so that a phosphorous compound may deposit on the surface of an exhaust gas catalyst and deteriorate the catalytic activity. Therefore, the addition amount of the MoDTP cannot be increased beyond a given level.

On the other hand, since MoDTC contains no phosphorous, increase in its addition amount does not give adverse influence upon the exhaust gas catalyst. However, excellent friction-mitigating effect is obtained by using in combination with zinc dithiophosphate (ZnDTP) as an anti-wear agent. ZnDTP, which has been frequently used as antioxidant and anti-wear agent in the engine oil, contains phosphorous and gives adverse influence upon the exhaust gas catalyst as mentioned above. Therefore, its addition amount is limited so that good friction-mitigating effect cannot unfavorably be maintained for a longer time. Further, it is proposed that MoDTC is used in combination with a sulfur-based extreme pressure additive (see Japanese Patent Publication No.5-83599). This combination does not afford adverse influence upon the exhaust gas catalyst, but it encounters a practically great problem upon the engine oil composition in that wear largely occurs in the valve train system.

US-A-5356547 describes a lubricating oil composition having a low coefficient of friction and reduced copper corrosion comprising (a) lubricating oil basestock, (b) 0.01 to less than 0.2% by weight, based on the oil composition, of at least one organomolybdenum compound selected from sulfurized oxymolybdenum dithiocarbamate and sulfurized oxymolybdenum organophosphorodithioate; and (c) from 0.5 to 7% by weight, based on the oil composition, of at least one organozinc compound selected from zinc dithiophosphate and zinc dithiocarbamate.

The present invention seeks to provide a lubricating oil for internal combustion engine which retains its lubricating effect after prolonged use without adversely influencing the catalytic effect on exhaust gases, while maintaining the content of friction modifying additives at low levels and the ability to suppress sludge formation after prolonged use. It seeks also to enable the lubricating oil to maintain its friction-reducing properties even after prolonged storage.

In accordance with the invention, there is provided a lubricating oil composition for an internal combustion engine, comprising:

a base oil selected from mineral oils, synthetic oils and mixtures thereof;
from 0.03 to 0.2% by weight, calculated as molybdenum (Mo), of an oxymolybdenum dithiocarbamate sulfide of the general formula

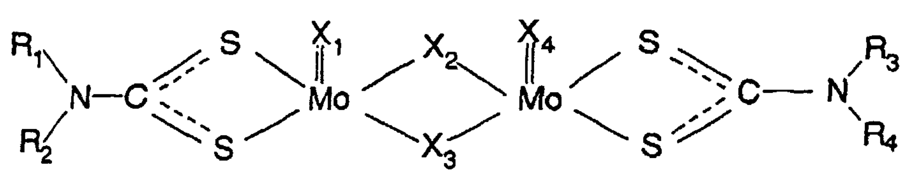

in which each of $R_1$, $R_2$, $R_3$ and $R_4$ is a hydrocarbon group having an average carbon number of not less than six, and each of $X_1$, $X_2$, $X_3$ and $X_4$ is oxygen or sulfur;
from 0.01 to 0.5% by weight, calculated as sulfur (S), of a zinc dithiocarbamate of the general formula:

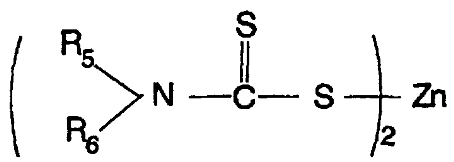

in which each of $R_5$ and $R_6$ is a hydrocarbon group having an average carbon number of not less than six; and from 0.01 to 0.2% by weight, calculated as phosphorus (P), of zinc dithiophosphate,

characterized in that the amounts of molybdenum [Mo] sulfur [S] and phosphorus [P] satisfy the relationship [S] >3[Mo]-2[P].

Preferably the average carbon number [C1] of $R_5$ and $R_6$ of the zinc dithiocarbamate and the average carbon number [C2] of $R_1$ through $R_4$ of the oxymolybdenum dithiocarbamate sulfide satisfy

$$[C1] - [C2] > -1.$$

Preferably, the composition contains oxymolybdenum dithiocarbamate sulfide in the amount of 0.03 to 0.2% by weight, when calculated as molybdenum (Mo), zinc dithiocarbamate in the amount of 0.03 to 0.4% by weight, when calculated as sulfur (S), and zinc dithiophosphate in the amount of 0.02 to 0.2% by weight, when calculated as phosphorus (P).

Preferably, each of $R_1$ to $R_4$ of the oxymolybdenum dithiocarbamate sulfide denotes a branched alkyl group having the average carbon number of 8 to 20.

Preferably, each of $R_5$ and $R_6$ of the zinc dithiocarbamate denotes a branched alkyl group having the average carbon number of 8 to 20.

Still further, it is preferred that the zinc dithiophosphate contains a branched alkyl group having the average carbon number of 3 to 20.

Consequently, it is possible to obtain a lubricating oil for internal combustion engine which can be stably used even after long use and storage, wherein the duration of low fuel economy is improved.

The present invention will be explained in detail with respect to each formulation component hereinafter.

The base oil to be used in the present invention is a mineral oil of a lubricating cut or a synthetic oil. As the base oil, which is used as a base component occupying a great part of the lubricating composition, any lubricating base oil may be used. It is preferable that a base oil having viscosity index of not less than 130, preferably not less than 140, is used in order to obtain particularly preferred friction lowering effect.

Specifically, as the mineral oil, use may be made of a lubricant base oil which is produced by obtaining a cut through distilling an ordinary pressure distillation residue of such as a paraffinic crude oil under reduced pressure, treating the resulting cut through extraction with a solvent such as furfural, purification by hydrogenation and dewaxing with a solvent such as MEK/toluene, a lubricant base oil produced by obtaining a deasphalted oil by deasphalting the above pressure-reduced distillation residue and treating it by any of the above appropriate processes, a highly purified base oil obtained through isomerization of slack wax and dewaxing an appropriate cut of the isomerized oil with a solvent of MEK/toluene, or an appropriate mixture thereof.

As the synthetic oil, use may be made of an β-olefin oligomer, a diester synthesized from a dibasic acid such as adipic acid and a primary alcohol, a polyol ester synthesized from a higher alcohol such as neopentyl glycol, trimethylol propane or pentaerythritol and a monobasic acid, alkyl benzene or polyoxyalkylene glycol or an appropriate mixture thereof. Further, needless to say, a mixed oil obtained by appropriately combining the mineral oil with the synthetic oil may be used as the base oil in the present invention, as a matter of course.

The oxymolybdenum dithiocarbamate sulfide (MoDTC) to be used in the present invention is expressed by the above chemical formula (1) in which $R_1$ through $R_4$ denote a hydrocarbon group having the average carbon number of not less than six, such as alkyl group, cycloalkyl group, aryl group, alkylaryl group, arylalkyl group, alkenyl group, etc., and may contain an ester group, an ether group, an alcohol group, a carboxyl group, etc. The average carbon number of $R_1$ through $R_4$ is normally not more than 24. An alkyl group having the average carbon number of 8 to 20, particularly those having a branch at β-position may be preferably used. Specific examples thereof include 2-ethylhexyl group, 2-hexyldecyl group, 2-heptylundecyl group, isotridecyl group, stearyl group and the like. With respect to $R_1$

through $R_4$, the same structure is normally used, but different structure may be used if the average value of the carbon number thereof is a predetermined value. Two or more MoDTCs may be mixed. In the formula, $X_1$ through $X_4$ denote oxygen atom or sulfur atom, and a ratio of oxygen atom to sulfur atom of $X_1$ through $X_4$ denote is preferably from 1/3 to 3/1. When almost all of $X_1$ through $X_4$ denote oxygen atom, the friction-reducing effect is small, whereas when almost all of $X_1$ through $X_4$ denote sulfur atom, the corrosion wear arises sometimes. Incidentally, the average carbon number is that obtained by averaging each number of carbons of $R_1$ through $R_4$. When using two or more MoDTCs, the average carbon number is that obtained by averaging according to the proportion thereof.

The addition amount of MoDTC relative to total weight of the lubricating oil is in such a range that MoTDC dissolves in the base oil and is 0.005 to 0.2% by weight, preferably 0.02 to 0.2% by weight, more preferably 0.03 to 0.10% by weight, when calculated as molybdenum (Mo). When the addition amount is less than this range, the friction-reducing effect is small, whereas when it exceeds this range, the friction-reducing effect becomes saturated and the cost increases. Therefore, it is not preferred.

Zinc dithiophosphate (ZnDTP) expressed typically by the following chemical formula (3):

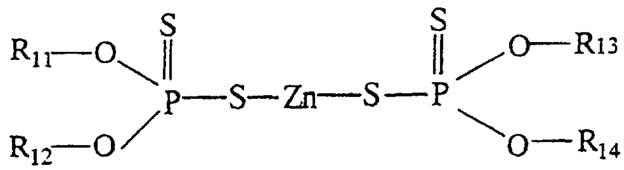

......(3)

In the formula, $R_{11}$ through $R_{14}$ denote a hydrocarbon group such as straight-chain and/or branched-chain alkyl or aryl group having the average carbon number of not less than three and aryl group. As $R_{11}$ through $R_{14}$, the alkyl groups having three to eighteen carbons are preferable. Specifically, mention may be made of propyl group, butyl group, pentyl group, hexyl group, octyl group, and lauryl group. $R_{11}$ through $R_{14}$ may be identical with or different from each other. It is also possible to use two or more ZnDTP having different $R_{11}$ through $R_{14}$ in combination. When the average carbon number of $R_{11}$ through $R_{14}$ is less than 3, the solubility in base oil is not sufficient. Those having the average carbon number of more than 20 are hardly obtained. The addition amount of ZnDTP relative to total weight of the lubricating oil is 0.01 to 0.2% by weight, more preferably 0.04 to 0.15% by weight, when calculated as phosphorus (P). In this range, the wear-preventing performance is not sufficinent. On the other hand, when it exceeds this range, influence of the phosphorous component upon the catalytic activity for the exhaust gas becomes greater.

The zinc dithiocarbamate to be used in the present invention is expressed by the chemical formula (2). In the formula, $R_5$ and $R_6$ denote a hydrocarbon group having the average carbon atom of not less than six, such as alkyl group, cycloalkyl group, aryl group, alkylaryl group, arylalkyl group, alkenyl group, etc., and may contain an ester group, an ether group, an alcohol group, a carboxyl group, etc. The average carbon number of $R_5$ and $R_6$ is normally not more than 24. An alkyl group having the average carbon number of 8 to 20 may be preferably used. Specific examples thereof include 2-ethylhexyl group, isotridecyl group, stearyl group and the like. With respect to $R_5$ and $R_6$, the same structure is normally used, but different structure may be used if the average value of the carbon number is a predetermined value. Two or more ZnDTCs may be mixed. Further, it is preferably to have the same substituents of $R_5$ and $R_6$ as those of $R_1$ through $R_4$ of the above oxymolybdenum dithiocarbamate sulfide.

Incidentally, when MoDTC and ZnDTC whose $R_5$ and $R_6$ have the average carbon number of less than 6 are allowed to coexist in the lubricating oil, a precipitation is produced in the lubricating oil and the storage stability is deteriorated. Therefore, it is not suitable as the lubricating oil for internal combustion engine. Since zinc dithiocarbamate causes little environmental problem in view of the pollution of the exhaust gas in case of burning in the engine, zinc dithiocarbamate is used. The addition amount of zinc dithiocarbamate relative to total weight of the lubricating oil is 0.01 to 0.5% by weight, preferably 0.05 to 0.4% by weight, more preferably 0.07 to 0.3% by weight, when calculated as sulfur (S). When the addition amount is less than this range, the life-increasing effect is small, whereas when it exceeds this range, the desired effect becomes saturated and the storage stability of the lubricating oil is sometimes deteriorated.

When the amount of zinc dithiocarbamate is expressed by [S] when calculated as sulfur (S) (% by weight), the composition of the invention should satisfy the following relation:

$$[S] > 3 \times [Mo] - 2 \times [P]$$

(wherein the addition amount of oxymolybdenum dithiocarbamate sulfide is expressed by [Mo] when calculated as molybdenum (Mo) (% by weight) and the addition amount of zinc dithiophosphate sulfide is expressed by [P] when

calculated as phosphorous (P). It is more preferred to satisfy the following relation:

$$[S] > 4 \times [Mo] - 2 \times [P].$$

This relation is considered as follows. It is necessary for reducing the friction coefficient to form a film similar to $MoS_2$. In order to form this film, oxymolybdenum dithiocarbamate sulfide and a sulfur resource (zinc dithiophosphate, zinc dithiocarbamate) in enough amount relative to the amount thereof are required to maintain the frictioan coefficient at lower level even after long use. It has been found as a result of the test that the sulfur resource (surfur (S) % by weight) is required in 3 times, preferably 4 times, as much as the addition amount of oxymolybdenum dithiocarbamate sulfide (molybdenum (Mo) % by weight). Accordingly, the required addition amount of zinc dithiocarbamate is that in which the amount of sulfur obtained from zinc dithiophosphate is subtracted from the required amount of sulfur derived from the addition amount of oxymolybdenum dithiocarbamate sulfide. Incidentally, the sulfur content of zinc dithiocarbamate is 2.065 times (about 2 times) as the phosphoroud content of zinc dithiocarbamate.

Accordingly, when the above relation is satisfied, the film similar to the stable $MoS_2$ and the friction-reducing effect appears.

Further, it is preferred to use an ashless dispersant as the other additive. Examples of the ashless dispersant include succinic acid imide, succinate, succinic acid amide, benzylamine, etc. Among them, a polymeric alkenyl succinic acid imide is preferably used. Specific examples of the polymeric alkenyl succinic acid imide include compounds expressed by the following chemical formulas (4) and (5).

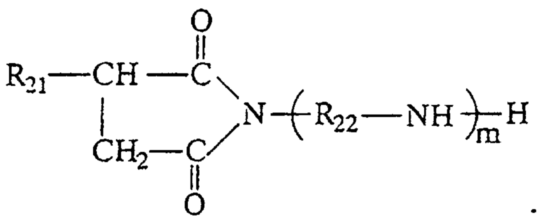

······(4)

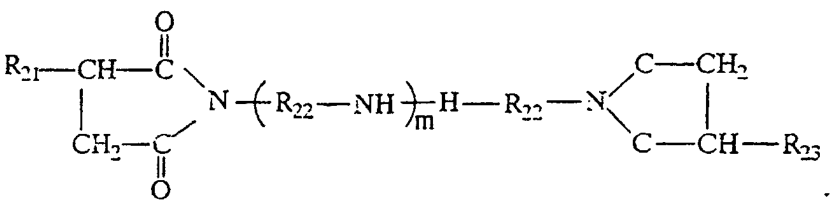

······(5)

In the formulas, $R_{21}$ an $R_{23}$ denote a hydroacrbon group having a molecular weight of 1500 to 3000, preferably alkyl group or alkenyl group. $R_{22}$ denotes an alkylene group having 2 to 4 carbons and m is 1 to 10, preferably 2 to 6. The addition amount may be 1 to 10% by weight, particularly 2 to 8% by weight. When the addition amount is less than 1% by weight, the sludge dispersancy is poor and, therefore, it is not preferred. On the other hand, when it exceeds this range, the effect corresponding to the addition amount is not exhibited. Therefore, it is not preferred.

In order to ensure the performance suitable for the intended use, lubricant oil additives other than the above may be appropriately added to the lubricating oil for internal combustion engine according to the present invention so as to improve the total performance. As such engine oil additives, mention may be made of so-called metallic detergents such as sulfonate, phenate and salicylate of alkaline earth metals such as Ca, Mg and Ba and alkaline metals such as Na, phenolic antioxidants such as bisphenol, amine antioxidant such as diphenylamine, and viscosity index improvers such as olefin copolymer or polymethacrylate. In addition, additives such as a pour point depressant, anti-corrosion agent and antifoaming agent may be appropriately added.

The lubricating oil for internal combustion engine of the present invention does not produce a precipitation after storage for a longer period of time and can be stably used for a longer period of time even at high temperature. The lubricating oil also has remarkable fuel-saving effect because of its friction decreasing effect and, therefore, it is suitable for a lubricating oil for internal combustion engine, particularly automobile engine.

## Claims

**1.** A lubricating oil composition for an internal combustion engine, comprising:

a base oil selected from mineral oils, synthetic oils and mixtures thereof;
from 0.03 to 0.2% by weight, calculated as molybdenum (Mo), of an oxymolybdenum dithiocarbamate sulfide of the general formula

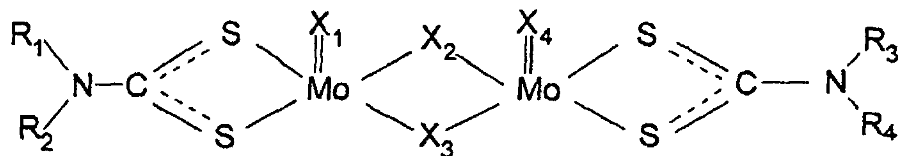

in which each of $R_1$, $R_2$, $R_3$ and $R_4$ is a hydrocarbon group having an average carbon number of not less than six, and each of $X_1$, $X_2$, $X_3$ and $X_4$ is oxygen or sulfur;
from 0.01 to 0.5% by weight, calculated as sulfur (S), of a zinc dithiocarbamate of the general formula:

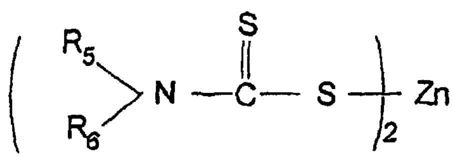

in which each of $R_5$ and $R_6$ is a hydrocarbon group having an average carbon number of not less than six; and from 0.01 to 0.2% by weight, calculated as phosphorus (P), of zinc dithiophosphate,

**characterized in that** the amounts of molybdenum [Mo] sulfur [S] and phosphorus [P] satisfy the relationship [S] >3[Mo]-2[P].

**2.** A lubricating oil composition according to claim 1, wherein the average carbon number [C1] of $R_5$ and $R_6$ and the average carbon number [C2] of $R_1$ to $R_4$ satisfy

$$[C1] - [C2] > - 1.$$

**3.** A lubricating oil composition according to claim 1 or claim 2, which contains the oxymolybdenum dithiocarbamate sulfide in an amount of 0.03 to 0.2% by weight, calculated as molybdenum (Mo), the zinc dithiocarbamate in an amount of 0.03 to 0.4% by weight, calculated as sulfur (S), and zinc dithiophosphate in an amount of 0.02 to 0.2% by weight calculated phosphorus (P).

**4.** A lubricating oil composition according to any one of claims 1 to 3, wherein each of $R_1$ to $R_4$ is a branched alkyl group having an average carbon number of 8 to 20.

**5.** A lubricating oil composition according to any one of claims 1 to 4, wherein each of $R_5$ and $R_6$ is a branched alkyl group having an average carbon number of 8 to 20.

**6.** A lubricating oil composition according to any one of claims 1 to 5, wherein the zinc dithiophosphate contains a branched alkyl group having an average carbon number of 3 to 20.

## Patentansprüche

**1.** Schmierölzusammensetzung für einen Verbrennungsmotor, welche enthält:

ein Grundöl, ausgewählt unter Mineralölen, synthetischen Ölen und Gemischen davon;

0,03 bis 0,2 Gew.-%, berechnet als Molybdän (Mo), eines Oxymolybdändithicarbamatsulfids der allgemeinen Formel

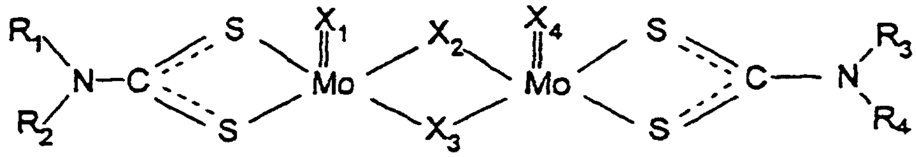

worin $R_1$, $R_2$, $R_3$ und $R_4$ jeweils eine Kohlenwasserstoffgruppe mit einer mittleren Kohlenstoffzahl von nicht weniger als 6 sind und $X_1$, $X_2$, $X_3$ und $X_4$ jeweils Sauerstoff oder Schwefel sind,

0,01 bis 0,5 Gew.-%, berechnet als Schwefel (S), eines Zinkdithiocarbamats der allgemeinen Formel

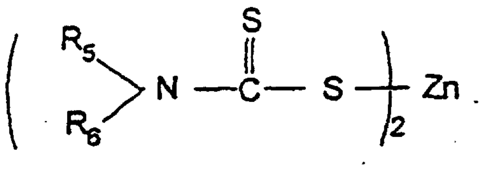

worin $R_5$ und $R_6$ jeweils eine Kohlenwasserstoffgruppe mit einer mittleren Kohlenstoffzahl von nicht weniger als 6 sind und

0,01 bis 0,2 Gew.-%, berechnet als Phosphor (P), eines Zinkdithiophosphats;

**dadurch gekennzeichnet, dass** die Mengen von Molybdän (Mo), Schwefel (S) und Phosphor (P) die Beziehung

$$[S] > 3[Mo] - 2[P]$$

erfüllen.

2. Schmierölzusammensetzung nach Anspruch 1, worin die mittlere Kohlenstoffzahl [C1] von $R_5$ und $R_6$ und die mittlere Kohlenstoffzahl [C2] von $R_1$ bis $R_4$ die Beziehung

$$[C1] - [C2] > -1$$

erfüllen.

3. Schmierölzusammensetzung nach Anspruch 1 oder 2, welche das Oxymolybdändithiocarbamatsulfid in einer Menge von 0,03 bis 0,2 Gew.-%, berechnet als Molybdän (Mo), das Zinkditihocarbamat in einer Menge von 0,03 bis 0,4 Gew.-%, berechnet als Schwefel (S), und Zinkdithiophosphat in einer Menge von 0,02 bis 0,2 Gew.-%, berechnet als Phosphor (P), enthält.

4. Schmierölzusammensetzung nach einem der Ansprüche 1 bis 3, worin $R_1$ bis $R_4$ jeweils eine verzweigte Alkylgruppe mit einer mittleren Kohlenstoffzahl von 8 bis 20 sind.

5. Schmierölzusammensetzung nach einem der Ansprüche 1 bis 4, worin $R_5$ und $R_6$ jeweils eine verzweigte Alkylgruppe mit einer mittleren Kohlenstoffzahl von 8 bis 20 sind.

6. Schmierölzusammensetzung nach einem der Ansprüche 1 bis 5, worin das Zinkdithiophosphat eine verzweigte Alkylgruppe mit einer mittleren Kohlenstoffzahl von 3 bis 20 ist.

## Revendications

**1.** Composition d'huile lubrifiante pour un moteur à combustion interne, qui comprend :

une huile de base sélectionnée parmi des huiles minérales, des huiles synthétiques et leurs mélanges ;
de 0,03 à 0,2 % en poids, calculé en molybdène (Mo), d'un dithiocarbamate sulfure d'oxymolybdène de formule générale :

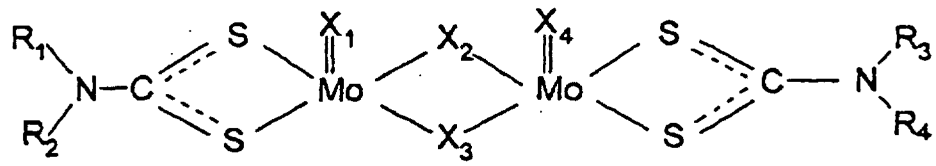

dans laquelle chacun des symboles $R_1$, $R_2$, $R_3$ et $R_4$ représente un groupe hydrocarboné possédant un nombre moyen d'atomes de carbone d'au moins six, et chacun des symboles $X_1$, $X_2$, $X_3$ et $X_4$ représente un atome d'oxygène ou de soufre ;

de 0,01 à 0,5 % en poids, calculé en soufre (S), d'un dithiocarbamate de zinc de formule générale :

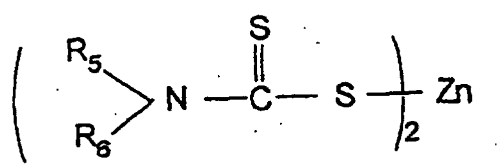

dans laquelle chacun des symboles $R_5$ et $R_6$ représente un groupe hydrocarboné possédant un nombre moyen d'atomes de carbone d'au moins six ; et

de 0,01 à 0,2 % en poids, calculé en phosphore (P), de dithiophosphate de zinc ;

**caractérisée en ce que** les quantités de molybdène [Mo], de soufre [S] et de phosphore [P] satisfont à la relation [S] > 3 [Mo] - 2 [P].

**2.** Composition d'huile lubrifiante selon la revendication 1, dans laquelle le nombre moyen d'atomes de carbone [C1] de $R_5$ et $R_6$ et le nombre moyen d'atomes de carbone [C2] de $R_1$ à $R_4$ satisfont à

$$[C1]-[C2]>-1.$$

**3.** Composition d'huile lubrifiante selon la revendication 1 ou 2, qui contient le dithiocarbamate sulfure d'oxymolybdène en une quantité de 0,03 à 0,2 % en poids, calculée en molybdène (Mo), le dithiocarbamate de zinc en une quantité de 0,03 à 0,4% en poids, calculée en soufre (S), et le dithiophosphate de zinc en une quantité de 0,02 à 0,2 % en poids, calculée en phosphore (P).

**4.** Composition d'huile lubrifiante selon l'une quelconque des revendications 1 à 3, dans laquelle chacun des symboles $R_1$ à $R_4$ représente un groupe alkyle ramifié possédant un nombre moyen d'atomes de carbone de 8 à 20.

**5.** Composition d'huile lubrifiante selon l'une quelconque des revendications 1 à 4, dans laquelle chacun des symboles $R_5$ et $R_6$ représente un groupe alkyle ramifié possédant un nombre moyen d'atomes de carbone de 8 à 20

**6.** Composition d'huile lubrifiante selon l'une quelconque des revendications 1 à 5, dans laquelle le dithiophosphate de zinc contient un groupe alkyle ramifié possédant un nombre moyen d'atomes de carbone de 3 à 20